Europäisches Patentamt

European Patent Office

Office européen des brevets

(11) Publication number: **0 276 069 B1**

# EUROPEAN PATENT SPECIFICATION

(45) Date of publication of patent specification: **16.12.92**

(51) Int. Cl.⁵: **C30B 25/02**, C30B 29/40, H01L 21/205, H01L 29/207

(21) Application number: **88300203.2**

(22) Date of filing: **12.01.88**

(54) **Vapor phase epitaxial growth of iron-doped, indium-based, compound group III-V semiconductors.**

(30) Priority: **20.01.87 US 4919**

(43) Date of publication of application:
**27.07.88 Bulletin 88/30**

(45) Publication of the grant of the patent:
**16.12.92 Bulletin 92/51**

(84) Designated Contracting States:
**DE ES FR GB IT NL SE**

(56) References cited:
**EP-A- 0 141 561
US-A- 4 062 706
US-A- 4 314 873**

**PATENT ABSTRACTS OF JAPAN, vol. 11, no. 187 (E-516)[2654], 16th June 1987, page 154 E 316; & JP-A-62 18 078 (NEC CORP.) 27-01-1987**

(73) Proprietor: **AMERICAN TELEPHONE AND TELEGRAPH COMPANY
550 Madison Avenue
New York, NY 10022(US)**

(72) Inventor: **Johnston, Wilbur Dexter, Jr.
30 Oak Knoll Road
Mendham New Jersey 07945(US)**
Inventor: **Long, Judith Ann
170 Myrtle Avenue
Millburn New Jersey 07041(US)**
Inventor: **Wilt, Daniel Paul
184 Mountainview Avenue
Scotch Plains New Jersey 07076(US)**

(74) Representative: **Watts, Christopher Malcolm Kelway, Dr. et al
AT&T (UK) LTD. AT&T Intellectual Property Division 5 Mornington Road
Woodford Green Essex IG8 OTU(GB)**

Rank Xerox (UK) Business Services

JOURNAL OF CRYSTAL GROWTH, vol. 70, no. 1/2, December 1984, pages 117-122, Elsevier Science Publishers B.V., Amsterdam, NL; C.W. TU et al.: "Effects of varying the input and downstream HCl and PH3 pressures and the H2 flow rate on the hydride growth of InP"

JOURNAL OF THE ELECTROCHEMICAL SOCI-ETY, vol. 124, no. 10, October 1977, pages 1635-1640; K. NAKAI et al.: "Growth of iron-doped epitaxial layers for GaAs field effect transistors"

## Description

This invention relates to a vapor phase epitaxial growth technique utilized to fabricate semiconductor devices such as light emitting devices, light detecting devices, and field-effect transistors.

A common problem in the fabrication of low threshold buried heterostructure (BH) lasers in the InGaAsP/InP materials system is the control of leakage currents (i.e., currents which bypass the active region of the device). These currents lead to high lasing threshold, low differential quantum efficiency, abnormal temperature dependence of threshold current, and rollover of the light-current (L-I) characteristic. All of these factors have a significant negative impact on the use of BH lasers in transmitters for fiber optic communication systems.

One possible solution to the problem of leakage current in buried heterostructure lasers is the controlled introduction of high resistivity material into the device structure. This high resistivity material could be used to block current flow through undesired leakage paths. Previously, high resistivity liquid phase epitaxial (LPE) $Al_{0.65}Ga_{0.35}As$ (lightly Ge-doped) material has been utilized for current confinement in AlGaAs/GaAs buried heterostructure lasers, but subsequent attempts to produce high resistivity LPE InP material for this purpose have not been successful. Deuteron bombardment has also been shown to produce highly resistive material during subsequent processing. In particular, because the high resistivity is related to deuteron implant damage, the resistivity anneals out at the high temperatures (e.g., above about 600°C) required for subsequent LPE growth.

In addition, bifurcated, reverse-biased p-n junctions have also been reported for constraining current to flow through the active region of InGaAsP/InP lasers. These blocking junctions have been fabricated by the implanation of Be into n-InP substrates, by the diffusion of Cd into n-InP substrates, and by the epitaxial growth of a p-InP layer onto an n-InP substrate. But, all of these devices are impaired to some extent by leakage currents because of the imperfect blocking characteristics of the reverse-biased junctions.

More recently, D. P. Wilt et al. reported in Applied Physics Letters, Vol. 44, No. 3, p. 290 (Feb. 1984) that InP/InGaAsP CSBH lasers with relatively low leakage currents and low lasing thresholds cans be fabricated by incorporating into the structure a high resistivity Fe-ion-implanted layer which constrains pumping current to flow through the active region. The high resistivity layer is produced by an Fe-ion implant into an n-type InP substrate followed by an annealing treatment prior to LPE growth. Although the resistivity of the Fe-ion-implanted layer is stable even after being subjected to the high temperatures characteristic of LPE growth, the thinness of the Fe-implanted layer (about 0.4 $\mu$m) renders it difficult to reproducibly position the thin active layer (about 0.1-0.2 $\mu$m thick) adjacent thereto. When the active layer is not so placed, shunt paths are created which allow leakage current to flow around the active layer. Hence, high performance (low threshold, high efficiency) devices are hard to fabricate reproducibly.

Others in the prior art have attempted to utilize hydride vapor phase epitaxy (VPE) to grow high resistivity Fe-doped InP, but his approach has been a difficult task because suitable volatile iron compounds typically cannot be transported using a hydrogen carrier gas at temperatures normally used for growth (e.g., T≥650°C). The growth of InP in an inert carrier gas is difficult as well and has been reported only for trichloride system (using $PCl_3$) when $PH_3$ was added to stimulate growth. See P. L. Giles et al., Journal of Crystal Growth, Vol. 61, p. 695 (1983).

## Summary of the Invention

In accordance with one aspect of our invention, a method of fabricating a device, which includes an iron-doped, indium-based, compound Group III-V semiconductor region, comprises the steps of (1) forming a precursor gas comprising a carrier gas, a volatile dopant compound, a volatile indium compound and a Group V hydride, (2) directing the precursor gas through a heated chamber to contact a heated deposition body, and (3) inducing deposition of the compound semiconductor on the body, characterized in that the carrier gas comprises an inert gas, the volatile dopant compound includes iron and is formed by reaction of HCl with solid iron and the volatile indium compound is formed by reaction of HCl with liquid indium, wherein the presence of hydrogen in said precursor gas is limited to that formed by reacting HCl with the iron and indium and to the pyrolysis of the Group V hydride in the heated chamber, such that excessive precipitation of iron is prevented, and the concentrations of said volatile indium compound at the body and of the hydride are maintained sufficient to result in deposition of the semiconductor.

In one embodiment, a semi-insulating, iron-doped, InP-based, compound Group III-V semiconductor region is fabricated by using a precursor gas comprising a nitrogen carrier, $FeCl_2$, InCl and $PH_3$, and the concentration of hydrogen in the precursor gas is limited by limiting the amount of pyrolysis of $PH_3$. This process is capable of producing a region having a resistivity greater than $10^8$ $\Omega$-cm which is suitable for use as a current-blocking region in a number of devices; e.g., light emitting devices, light detecting devices and FETs.

## Brief Description of the Drawing

The invention, together with its various features and advantages, can be readily understood from the following, more detailed description taken in conjunction with the accompanying drawing, in which, in the interests of clarity, the figures have not been drawn to scale:

FIG. 1 is an isometric view of a CSBH light emitting device fabricated in accordance with one embodiment of the invention;

FIG. 2 is an end view of another CSBH device fabricated in accordance with another embodiment of the invention; and

FIG. 3 is an end view of a DC-PBH device fabricated in accordance with still another embodiment of the invention.

## Detailed Description

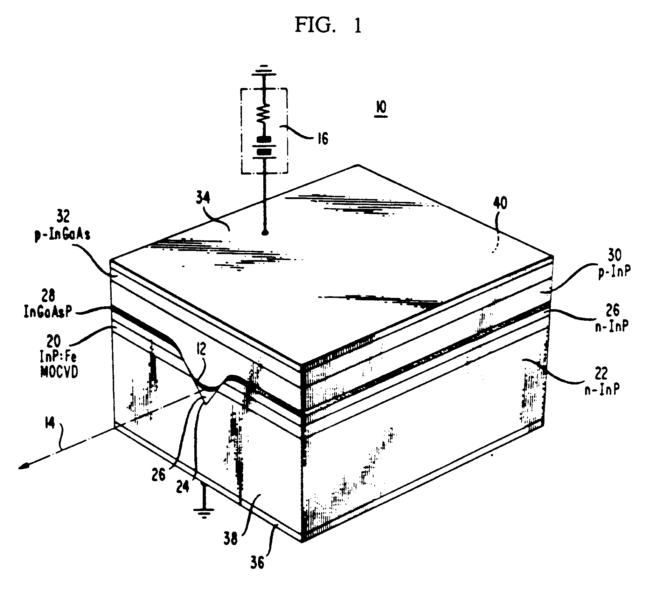

The semiconductor light emitting device in FIG. 1 may be used as a laser or as an edge-emitting LED. In either case, the device 10 includes an active region 12 in which the recombination of electrons and holes causes radiation to be emitted at a wavelength characteristic of the bandgap of the semiconductor material of the active region (e.g., about 1.0-1.65 $\mu$m for InGaAsP depending on the specific composition of the alloy). The radiation is direction generally along axis 14 and is primarily stimulated emission in the case of a laser and primarily spontaneous emission in the case of an LED.

This recombination radiation is generated by forward-biasing a p-n junction which causes minority carriers to be injected into the active region. Source 16, illustratively depicted as a battery in series with a current-limiting resistor, supplies the forward bias voltage and, in addition, provides pumping current at a level commensurate with the desired optical output power. In a laser, the pumping current exceeds the lasing current threshold.

In general, the device includes means for constraining the pumping current to flow in a relatively narrow channel through the active region 12. As illustrated, this constraining means comprises a bifurcated, high resistivity Fe-doped InP epitaxial layer 20, and the active region 12 has the shape of a stripe which lies in the rectangular opening (top view) of the bifurcated layer 20. Note, in the case of a surface emitting LED the layer 20, rather than being bifurcated, might take the shape of an annulus surround a cylindrical or mesa-like active region.

The structure shown in FIG. 1 is known as a channeled-substrate buried heterostructure (CSBH) laser which includes an n-InP substrate 22 and an Fe-doped high resistivity InP epitaxial layer 20 which is bifurcated by a groove 24. The groove is etched or otherwise formed through layer 20 into substrate 22. A preferred technique for controllably etching the groove in the shape of a V is described in U.S. Patent No. 4,595,454.

The following essentially lattice-matched epitaxial layers are then epitaxially grown on the etched wafer: an n-InP first cladding layer 26 (the central portion of which fills at least the bottom portion of groove 24); an unintentionally doped InGaAsP layer 28; a p-InP second cladding layer 30; and a p-InGaAs (or p-InGaAsP) contact-facilitating layer 32. Layer 28 includes crescent-shaped active region 12 which, in practice, becomes separated from the remainder of layer 28 because epitaxial growth does not take place along the top edges of the groove 24. Provided that nonradiative recombination at the interface with high resistivity layer 20 is not significant, the active layer is preferably vertically positioned within the thickness of the high resistivity layer 20 in order to reduce leakage current. However, if the active layer is below layer 20, but near enough thereto (i.e., $\leq 1$ $\mu$m away), leakage currents are still significantly reduced and nonradiative recombination at the layer 20 interface becomes much less of a problem.

Although the high resistivity InP:Fe layer 20 is formed directly on the substrate 22, it may also be formed on an epitaxial buffer layer (not shown) grown on the substrate. For CSBH InP/InGaAsP lasers a resistivity in excess of about $1 \times 10^6$ $\Omega$-cm is desirable. In either case, this aspect of the invention utilizes the growth of high resistivity InP:Fe layer 20 usisng hydride VPE with $N_2$ as an inert carrier under conditions of limited $PH_3$ pyrolysis in the reactor. By using an inert carrier and limiting the presence of $H_2$ to that formed by the reaction of HCl with $In_{(l)}$ and $Fe_{(s)}$ and the pyrolysis of $PH_3$, the invention achieved transport of sufficient $FeCl_2$ (and hence limited the excessive precipitation of iron by hydrogen) to produce InP:Fe with a resistivity of $> 10^8$ $\Omega$-cm.

A high resistivity layer prepared by this hydride VPE process maintains its high resistivity even after being subjected to the high temperatures of subsequent process (e.g., LPE) steps.

Electrical contact is made to the device via metal electrodes 34 and 36 on layer 32 and substrate 22, respectively. Source 16 is connected across electrodes 34 and 36.

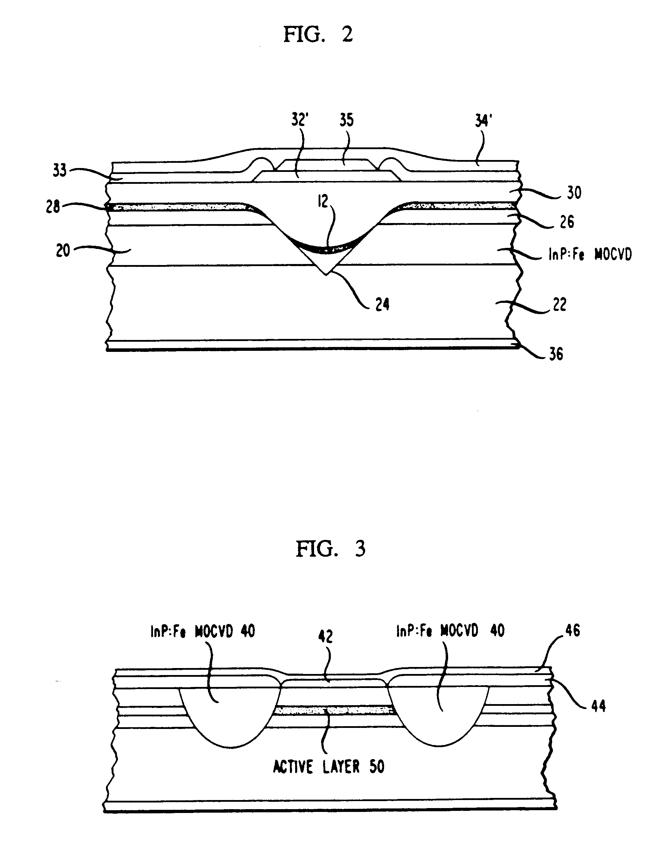

Although a broad-area cosdntact is depicted in FIG. 1 by layer 32 and electrode 34, it also is possible to delineate a stripe geometry contact as shown in FIG. 2. Here components with primed notation in FIG. 2 correspond to those with the same reference numerals in FIG. 1. Thus, the contact-facilitating layer 32' is etched to form a stripe and is aligned within the stripe-shaped open-

ing of $SiO_2$ layer 33. A stripe-shaped metal contact 35 is formed on layer 32' in the opening of $SiO_2$ layer 33, and a broad area electrode 34' is then formed over the top of the device. A contact configuration of this type reduces device capacitance and hence increases high speed performance.

The CSBH laser also includes means for providing optical feedback of the stimulated emission, typically a pair of separated, parallel, cleaved facets 38 and 40 which form an optical cavity resonator as shown in FIG. 1. The optical axis of the resonator and the elongated direction of the stripe-shaped active region 12 are generally parallel to one another. Other feedback techniques are also suitable, however, including well-known distributed feedback gratings, for example.

This example describes the fabrication of high resistivity InP:Fe epitaxial layers by a hydride VPE process. These high resistivity layers can be incorporated into CSBH lasers (as described above) as well as into other device structures as described hereinafter. The various materials, dimensions, concentrations, etc., are given by way of illustration only and are not intended to limit the invention unless otherwise stated.

The reactor used for the growth of the InP:Fe is described by R. F. Karlicek et al. in Journal of Applied Physics, Vol. 60, p. 794 (1986). The source gases included HCl and $PH_3$ mixtures (5% and 2%, respectively) in ultra high purity $N_2$), and the $N_2$ carrier gas (99.999% pure) was obtained from a standard compressed gas cylinder. The concentration of the input was reactive gases was selected using electronic mass flow controllers. The transport of iron as the dichloride $FeCl_2$ was accomplished by flowing HCl (5% in $N_2$) through iron powder (99.999% pure) placed on a quartz frit which was located downstream of the $In_{(l)}$ source in the reactor source region. The $In_{(l)}$ source temperature, the Fe source temperature, and the growth temperature were kept constant at about 700°C. Between growth experiments, Pd-purified $H_2$ was made to flow through the reactor in place of $N_2$.

Using an optical spectrometer which monitored the wavelength region between 200 and 330 nm, the extent of $PH_3$ pyrolysis was determined by measuring the absorbance of $P_4$ at 230 nm. Since $P_4$ is the dominant species (except for unpyrolyzed $PH_3$) the concentration of $P_2$ was not monitored optically and was not included in the computation of the degree of $PH_3$ pyrolysis during growth. The transport of $FeCl_2$ was also monitored optically, and the concentration was computed from published thermodynamic data for the Fe-Cl system.

As noted earlier, by using an inert carrier gas and limiting the presence of hydrogen to that formed by the reaction of HCl with liquid indium and solid iron and by the pyrolysis of phosphine, the invention achieves sufficient transport of $FeCl_2$ (and hence limited the escessive precipitation of iron by hydrogen) to produce InP:Fe with a resistivity of $> 10^8$ $\Omega$-cm.

The growth of InP:Fe was performed on <100> oriented InP:S substrates which were degreased prior to placement in the reactor. Following the preheating of the substrate under a dilute $PH_3$ flow, a brief etch was performed by initiating the flow of HCl through the Fe source. Growth was initiated by starting the flow of HCl over the $In_{(l)}$ source region. The specific growth conditions were as follows: $PH_3$ pressure of 1755 Pa ($17.9 \times 10^{-3}$ atm), InCl pressure of 390 Pa ($4.0 \times 10^{-3}$ atm), HCl pressure of 9.8 Pa ($0.1 \times 10^{-3}$ atm), and total flow of 2250 sccm. The combination of the inert carrier gas (e.g., $N_2$), the volatile dopant compound (e.g., $FeCl_2$), the volatile indium compound (e.g., InCl) and the Group V hydride (e.g., $PH_3$) are known as a precursor gas. These conditions produced in InP:Fe growth rates of 16 $\mu$m/hr. The resulting InP:Fe layer was measured to have a resistivity of about $2.4 \times 10^8$ $\Omega$-cm.

In addition, the invention contemplates the ability to grow by hydride VPE InP-based epitaxial layers having the physical characteristics (e.g., resistivities of $\geq 10^6$ $\Omega$-cm and thicknesses of $\geq 1$ $\mu$m) of Fe-doped InP-based layers grown by MOCVD. These InP-based layers include, for example, InGaP, InAsP, InGaAsP and InGaAlP.

Moreover, while the invention has been discussed with reference to lasers and LEDs, it will be appreciated by those skilled in the art that it is applicable to other semiconductor devices (e.g., photodiodes, FETs) in which substantial current is prevented from flowing through a region of the device.

One alternative laser structure which may be fabricated in accordance with the invention is known as the double channel planar buried heterostructure (DCPBH). The conventional DCPBH laser is described generally by I. Mito et al. in Journal of Lightwave Technology, Vol. LT-1, No. 1, p. 195 (1983). It employs LPE regrowth in the channels to form reverse-biased blocking junctions which constrain current to flow through the elongated mesa containing the active layer. In accordance with a DCPBH embodiment of the invention shown in FIG. 3, however, the LPE regrowth of blocking junctions is replaced by growth of InP:Fe zones 40 on each side of the mesa. A restricted (e.g., stripe geometry) contact 42 is delineated on top of the mesa by a patterned dielectric layer 44 (e.g., $SiO_2$) and an electrode 46 overlays the top of the device. In this fashion, current is constrained by the InP:Fe zones 40 and the dielectric layer 44 to flow essentially only through the mesa and hence through the active layer 50.

Finally, it is well known that the active region of the devices described above may include a single active layer or a composite several layers at least one of which is active (in the light-emitting sense). Thus, in a 1.55 $\mu$m InP/InGaAsP laser, the active region may include an InGaAsP layer which emsits light at 1.55 $\mu$m adjacent another InGaAsP layer ($\lambda = 1.3$ $\mu$m) which serves an anti-meltback function during LPE growth. Moreover, several active layers emitting at different wavelengths are also embraced within the definition of an active region.

## Claims

1.  A method of fabricating a device, which includes an iron-doped, indium-based, compound Group III-V semiconductor region, comprising the steps of (1) forming a precursor gas comprising a carrier gas, a volatile dopant compound, a volatile indium compound and a Group V hydride, (2) directing said precursor gas through a heated chamber to contact a heated deposition body, and (3) inducing deposition of said compound semiconductor on said body, characterized in that the carrier gas comprises an inert gas, the volatile dopant compound includes iron and is formed by reaction of HCl with solid iron and the volatile indium compound is formed by reaction of HCl with liquid indium, wherein the presence of hydrogen in said precursor gas is limited to that formed by reacting HCl with the iron and indium and to the pyrolysis of the Group V hydride in the heated chamber, such that excessive precipitation of iron is prevented, and the concentrations of said volatile indium compound at said body and of said Group V hydride are maintained sufficient to result in said deposition.

2.  The method of claim 1 wherein the presence of hydrogen is limited by limiting the amount of pyrolysis of said hydride.

3.  The method of claim 2 wherein said inert carrier gas comprises nitrogen.

4.  The method of claim 2 or claim 3 wherein said volatile indium compound comprises InCl.

5.  The method of any of claims 2 to 4 wherein said volatile dopant compound comprises $FeCl_2$.

6.  The method of any of claims 2 to 5 wherein said hydride comprises phosphine.

7.  The method of claim 6 wherein said region comprises high resistivity InP.

8.  The method of claim 7 wherein said region has a resistivity greater than $10^8$ $\Omega$-cm.

9.  The method of claim 2 wherein said region comprises high resistivity InP and said carrier gas comprises nitrogen, said volatile indium compound comprises InCl, said volatile dopant compound comprises $FeCl_2$, and said hydride comprises phosphine.

10. The method of any of claims 1 to 9 wherein said body has a mesa thereon and said deposition forms said region adjacent said mesa.

## Patentansprüche

1.  Verfahren zur Herstellung einer Einrichtung, die einen eisendotierten, auf Indium basierenden, Verbindungshalbleiterbereich der Gruppe III - V enthält mit den Schritten: (1) Formen eines Vorläufergases, das ein Trägergas, eine flüchtige Dotierstoffverbindung, eine flüchtige Indiumverbindung und ein Hydrid der Gruppe V enthält, (2) Richten des Vorläufergases durch eine geheizte Kammer, um mit einem beheizten Abscheidungskörper in Kontakt zu treten, und (3) Einleiten der Abscheidung des Verbindungshalbleiters auf dem Körper, dadurch gekennzeichnet, daß das Trägergas ein Inertgas enthält, die flüchtige Dotierstoffverbindung Eisen enthält und durch Reagieren von HCl mit festem Eisen gebildet wird, und die flüchtige Indiumverbindung durch Reagieren von HCl mit flüssigem Indium gebildet wird, wobei die Anwesenheit von Wasserstoff in dem Vorläufergas auf diejenige beschränkt ist, die durch Reagieren von HCl mit dem Eisen und dem Indium und durch die Pyrolyse des Hydrids der Gruppe V in der beheizten Kammer gebildet ist, so daß überschüssige Ausfällung von Eisen verhindert ist, und die Konzentration der flüchtigen Indiumverbindung bei diesem Körper und bei dem Hydrid der Gruppe V ausreichend aufrechterhalten werden, um zu der Abscheidung zu führen.

2.  Verfahren nach Anspruch 1, dadurch gekennzeichnet, daß die Anwesenheit des Wasserstoffs durch die Beschränkung des Umfangs der Pyrolyse des Hydrids beschränkt ist.

3.  Verfahren nach Anspruch 2, dadurch gekennzeichnet, daß inerte Trägergas Stickstoff enthält.

**4.** Verfahren nach Anspruch 2 oder 3, dadurch gekennzeichnet,daß die flüchtige Indiumverbindung InCl enthält.

**5.** Verfahren nach einem der Ansprüche von 2 bis 4, dadurch gekennzeichnet, daß die flüchtige Dotierstoffverbindung $FeCl_2$ enthält.

**6.** Verfahren nach einem der Ansprüche von 2 bis 5, dadurch gekennzeichnet, daß das Hydrid Phosphin enthält.

**7.** Verfahren nach Anspruch 6, dadurch gekennzeichnet, daß der Bereich InP mit hohem spezifischen Widerstand enthält.

**8.** Verfahren nach Anspruch 7, dadurch gekennzeichnet, daß der Bereich einen spezifischen Widerstand von größer als $10^8$ Ω-cm hat.

**9.** Verfahren nach Anspruch 2, dadurch gekennzeichnet, daß der Bereich InP mit hohem spezifischen Widerstand enthält und das Trägergas Stickstoff enthält, die flüchtige Indiumverbindung InCl enthält, die flüchtige Dotierstoffverbindung $FeCl_2$ enthält und das Hydrid Phosphin enthält.

**10.** Verfahren nach einem der Ansprüche 1 - 9, dadurch gekennzeichnet, daß auf dem Körper eine Mesa ist und daß die Abscheidung den Bereich angrenzend zu der Mesa bildet.

**Revendications**

**1.** Un procédé de fabrication d'un dispositif, qui comprend une région de semiconducteur composé des Groupes III-V à base d'indium et dopée avec du fer, comprenant les étapes suivantes : (1) on forme un gaz précurseur comprenant un gaz porteur, un composé de dopant volatil, un composé d'indium volatil et un hydrure du Groupe V, (2) on fait passer ce gaz précurseur à travers une chambre chauffée pour qu'il vienne en contact avec un corps de dépôt chauffé, et (3) on provoque le dépôt du semiconducteur composé sur ce corps, caractérisé en ce que le gaz porteur consiste en un gaz inerte, le composé de dopant volatil comprend du fer et il est formé par réaction de HCl avec du fer solide, et le composé d'indium volatil est formé par réaction de HCl avec de l'indium liquide, et la présence d'hydrogène dans le gaz précurseur est limitée à l'hydrogène qui est formé par réaction de HCl avec le fer et l'indium et par la pyrolyse de l'hydrure du Groupe V dans la chambre chauffée, de façon à éviter une précipitation excessive de fer, et les concentrations du composé d'indium volatil sur le corps précité et de l'hydrure du Groupe V sont maintenues à une valeur suffisante pour que le dépôt précité ait lieu.

**2.** Le procédé de la revendication 1, dans lequel on limite la présence d'hydrogène en limitant le degré de pyrolyse de l'hydrure.

**3.** Le procédé selon la revendication 2 dans lequel le gaz porteur inerte consiste en azote.

**4.** Le procédé de la revendication 2 ou de la revendication 3 dans lequel le composé d'indium volatil consiste en InCl.

**5.** Le procédé de l'une quelconque des revendications 1 à 4, dans lequel le composé de dopant volatil consiste en $FeCl_2$.

**6.** Le procédé de l'une quelconque des revendications 2 à 5, dans lequel l'hydrure consiste en phosphine.

**7.** Le procédé de la revendication 6, dans lequel la région précitée consiste en InP à résistivité élevée.

**8.** Le procédé de la revendication 7, dans lequel la région précitée a une résistivité supérieure à $10^8$ Ω-cm.

**9.** Le procédé de la revendication 2 dans lequel la région précitée consiste en InP à résistivité élevée, et le gaz porteur consiste en azote, le composé d'indium volatil consiste en InCl, le composé de dopant volatil consiste en $FeCl_2$, et l'hydrure consiste en phosphine.

**10.** Le procédé de l'une quelconque des revendications 1 à 9, dans lequel une mésa est formée sur le corps précité, et le dépôt forme la région précitée en position adjacente à cette mésa.

FIG. 1

## FIG. 2

## FIG. 3

ACTIVE LAYER 50